# EUROPÄISCHE PATENTANMELDUNG

(11) **EP 1 903 834 A1**
(43) Veröffentlichungstag der Anmeldung: **26.03.2008**
(21) Anmeldenummer: 06019939.5
(22) Anmeldetag: 22.09.2006
(51) Int. Cl.: H04R 25/00

(54) **Hörvorrichtung mit Magnetfeldsensor und Schaltkreismontageverfahren**

(71) Anmelder: Siemens Audiologische Technik GmbH, 91058 Erlangen (DE)
(72) Erfinder: Weidner, Tom, 91056 Erlangen (DE)
(74) Vertreter: Maier, Daniel Oliver

(57) **Zusammenfassung**

Der Aufwand und der Platzbedarf bei der Montage eines Magnetfeldsensors auf einer Leiterplatte einer Hörvorrichtung sollen reduziert werden. Hierzu ist vorgesehen, dass ein Magnetfeldsensor (25) eingesetzt wird, der als reines IC-Substrat ohne Gehäuse vorliegt. Aufgrund des Verzichts auf ein Gehäuse ist sein Bauvolumen entsprechend reduziert. Außerdem kann er so mit einer IC-Bestückungstechnik auf einer Leiterplatte (20) vollkommen automatisch montiert und angeschlossen werden.

## Beschreibung

Die vorliegende Erfindung betrifft eine Hörvorrichtung, insbesondere ein Hörgerät, mit einer Leiterplatte, einer Signalverarbeitungseinrichtung, die auf die Leiterplatte montiert ist, und einem Magnetfeldsensor, der auf die Leiterplatte montiert und an die Signalverarbeitungseinrichtung angeschlossen ist. Darüber hinaus betrifft die vorliegende Erfindung ein Verfahren zur Montage eines Schaltkreises einer Hörvorrichtung und insbesondere eines Hörgeräts durch Bereitstellen einer Leiterplatte, Montieren einer Signalverarbeitungseinrichtung auf die Leiterplatte und Montieren sowie Anschließen eines Magnetfeldsensors auf der Leiterplatte. Unter dem Begriff Hörvorrichtung kann hier auch ein Kopfhörer, ein Headset und andere am Ohr tragbare Geräte verstanden werden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Indem-Ohr-Hörgeräte (IdO), Concha-Hörgeräte bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

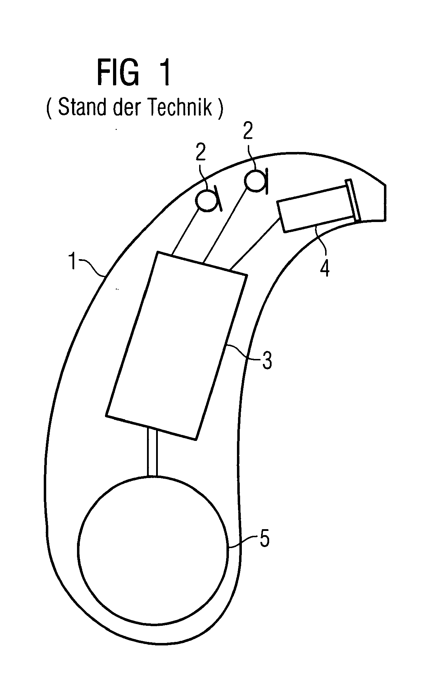

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgerät dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Bei Hörgeräten ist eine Umschaltung zwischen verschiedenen Hörprogrammen (Autophone) mithilfe eines Magneten bekannt. Dazu wird ein Magnetfeldsensor oder Magnetschalter benötigt, der in der Regel aufwendig manuell eingebaut werden muss und je nach Typ noch weitere technische Nachteile besitzt.

Beispielsweise werden als Magnetschalter so genannte Reedkontakte eingesetzt. Dies sind mechanische Bauelemente, die durch geeignete Materialauswahl und Technik bei Vorliegen eines bestimmten magnetischen Flusses einen elektrischen Kontakt schließen. Derartige Reed-Schalter haben jedoch den Nachteil, dass sie relativ groß sind und außerdem bewegliche Teile in einem Glasgehäuse besitzen. Des Weiteren haben sie eine hohe Schockempfindlichkeit und können nur durch einen komplizierten Herstellungsprozess, der aufwendiges und gefahrenträchtiges Biegen einschließt, gewonnen werden.

Als Magnetfeldsensoren werden ferner Hall-Sensoren und GMR-Sensoren (giant-magneto-resistance) eingesetzt. Diese Sensoren werden jedoch in einer Bauform eingesetzt, die ebenfalls gravierende Nachteile besitzt. So werden sie beispielsweise in üblichen SMD-Gehäusen verarbeitet, die in aller Regel ein erhebliches Volumen aufweisen. Gerade bei IdO-Hörgeräten sind aber keine derartigen SMD-Bauteile einsetzbar, da diese typischerweise zu groß sind.

Die Aufgabe der vorliegenden Erfindung besteht somit darin, Hörvorrichtungen und insbesondere auch IdO-Hörgeräte mit kleinen, robusten Magnetfeldsensoren vorzuschlagen. Außerdem soll ein entsprechendes Montageverfahren für die Schaltkreise derartiger Hörvorrichtungen angegeben werden.

Erfindungsgemäß wird diese Aufgabe gelöst durch eine Hörvorrichtung mit einer Leiterpatte, einer Signalverarbeitungseinrichtung, die auf die Leiterplatte montiert ist, und einem Magnetfeldsensor, der auf die Leiterplatte montiert und an die Signalverarbeitungseinrichtung angeschlossen ist, wobei der Magnetfeldsensor als reines IC-Substrat vorliegt und gehäuselos auf die Leiterplatte montiert ist.

Ferner wird erfindungsgemäß bereitgestellt ein Verfahren zur Montage eines Schaltkreises einer Hörvorrichtung durch Bereitstellen einer Leiterplatte, Montieren einer Signalverarbeitungseinrichtung auf die Leiterplatte sowie Montieren und Anschließen eines Magnetfeldsensors auf der Leiterplatte, wobei der Magnetfeldsensor als reines IC-Substrat gehäuselos vorliegt und so mit einer IC-Bestückungstechnik auf der Leiterplatte montiert und angeschlossen wird.

In vorteilhafter Weise können somit in Hörvorrichtungen sehr kleine Magnetfeldsensoren, die als reines IC-Substrat vorliegen, eingesetzt werden. Darüber hinaus können diese kleinen IC-Substrate vollkommen automatisch auf der Leiterplatte der Hörvorrichtung montiert und angeschlossen werden.

Gemäß einer speziellen Ausführungsform handelt es sich bei dem Magnetfeldsensor um einen Hall-Sensor. Dieser ist kostengünstig herzustellen und besitzt keine mechanisch bewegbaren Teile.

Entsprechend einer weiteren Ausführungsform kann als Magnetfeldsensor ein GMR-Sensor eingesetzt werden. Dieser ist sehr empfindlich gegenüber Magnetfeldern und besitzt ebenfalls keine mechanisch beweglichen Teile.

Zum Bestücken der Leiterplatte mit dem als reines IC-Substrat gehäuselos vorliegenden Magnetfeldsensor wird vorzugsweise die Flip-Chip-Technik verwendet. Diese ist eine sehr bewährte IC-Bestückungstechnik, mit der ein hoher Automatisierungsgrad erreicht werden kann. Alternativ zu dieser Flip-Chip-Technik kann auch jedes andere Kontaktierungsverfahren für ungehäuste Halbleiter eingesetzt werden. Darüber hinaus kann hier für das Bestücken auch die CSP-Technik (chip-scale-package) sowie die wire-bond-Technik verwendet werden.

Die vorliegende Erfindung wird nun anhand der beigefügten Zeichnungen näher erläutert, in denen zeigen:
- FIG 1: eine Prinzipskizze zum Aufbau der Elektronik eines Hörgeräts;
- FIG 2: einen Schaltkreis mit einem Magnetfeldsensor gemäß dem Stand der Technik und
- FIG 3: einen Schaltkreis mit einem ungehäusten Magnetfeldsensorchip gemäß der vorliegenden Erfindung.

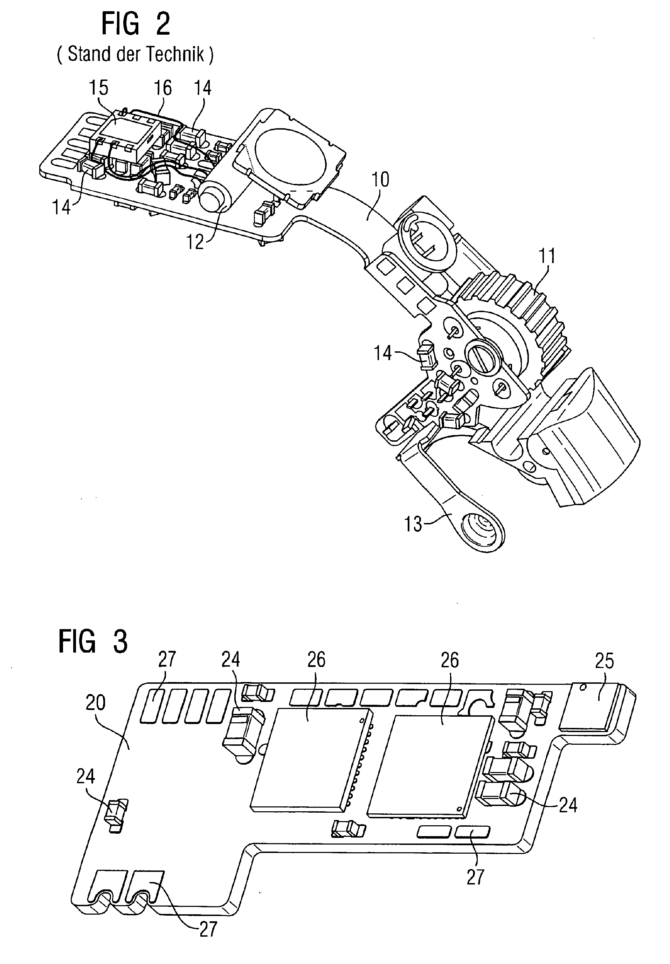

Das nachfolgend näher geschilderte Ausführungsbeispiel stellt eine bevorzugte Ausführungsform der vorliegenden Erfindung dar. Zum besseren Verständnis der Erfindung wird jedoch zunächst anhand von FIG 2 ein Schaltkreis für die Signalverarbeitung eines Hörgeräts gemäß dem Stand der Technik näher erläutert. Demnach sind auf einer Leiterplatte 10 zahlreiche elektronische Bauelemente, wie beispielsweise ein Lautstärkesteller 11 oder eine Telefonspule 12 angeordnet. Außerdem ist ein Batteriekontakt 13 zur Stromversorgung an die Leiterplatte 10 angeschlossen. Weiterhin sind zahlreiche SMD-Bauteile 14 auf der Leiterplatte 10 kontaktiert. Schließlich ist auch ein verhältnismäßig voluminöser Magnetfeldsensor 15, der als SMD-Bauteil ausgebildet ist, auf der Leiterplatte 10 befestigt. Er ist mit Litzen 16 manuell an der Leiterplatte 10 angelötet.

Erfindungsgemäß ist der voluminöse, gehäuste Magnetfeldsensor 15, der sehr aufwendig kontaktiert werden muss, entsprechend FIG 3 durch ein gehäuseloses IC-Bauteil 25 ersetzt. Da es aus dem reinen IC-Substrat besteht, weist es minimale Größe auf. Es kann entsprechend dem Hall-Effekt oder dem GMR-Effekt als Magnetfeldsensor realisiert sein.

Die Gestalt des IC-Bauteils 25 erlaubt eine vollkommen automatische Bestückung auf der Leiterplatte 20. Beispielsweise kann die Bestückung durch Flip-Chip-Technik direkt auf die Leiterplatte 20 des Hörgeräts erfolgen. Alternativ können auch andere IC-Bestückungstechniken eingesetzt werden, wie z. B. CSP-Technik oder ähnliches.

In dem Beispiel von FIG 3 sind neben dem Magnetfeldsensorchip 25 auch weitere Chips 26 durch Flip-Chip-Technik montiert. Außerdem befinden sich mehrere SMD-Bauteile 24 auf der Leiterplatte 20. Zur Kontaktierung weiterer Elektronikkomponenten sind Kontaktpads 27 vorgesehen.

Der in FIG 3 gezeigte Schaltkreis weist den Vorteil auf, dass durch die Verwendung der reinen Dice (IC-Substrat) für den Magnetfeldsensor nur minimaler Platzbedarf besteht. Dies bedeutet, dass die eingesetzten Sensoren kleiner als die bislang verwendeten sind, da diese stets zusätzlich in einem IC-Gehäuse (package) verpackt sind.

Vorteilhaft an dieser Lösung mit reinem IC-Substrat ist, wie bereits angedeutet, weiterhin, dass durch die automatisierte Bestückung, z. B. mittels Flip-Chip-Technik eine extrem schnelle, robuste, platzsparende und funktionssichere Montage des Magnetfeldsensors möglich ist. Außerdem werden keine Litzen mehr benötigt und ein Biegen und Formen von eventuellen Anschlüssen entfällt. Ebenso müssen die Kontakte und der Sensor selbst nicht mehr isoliert werden, da alle elektrischen Kontakte zur Leiterplatte zeigen und dort durch Vergussmasse (underfill) bereits geschützt sind.

## Patentansprüche

1. Hörvorrichtung mit
- einer Leiterpatte (20),
- einer Signalverarbeitungseinrichtung, die auf die Leiterplatte (20) montiert ist, und
- einem Magnetfeldsensor (25), der auf die Leiterplatte (20) montiert und an die Signalverarbeitungseinrichtung angeschlossen ist,
**dadurch gekennzeichnet, dass**
- der Magnetfeldsensor (25) als reines IC-Substrat vorliegt und gehäuselos auf die Leiterplatte (20) montiert ist.

2. Hörvorrichtung nach Anspruch 1, wobei der Magnetfeldsensor (25) ein Hall-Sensor ist.

3. Hörvorrichtung nach Anspruch 1, wobei der Magnetfeldsensor (25) ein GMR-Sensor ist.

4. Hörvorrichtung nach einem der vorhergehenden Ansprüche, wobei die Leiterplatte als Hybrid ausgeführt ist.

5. Verfahren zur Montage eines Schaltkreises einer Hörvorrichtung durch
- Bereitstellen einer Leiterplatte (20),
- Montieren einer Signalverarbeitungseinrichtung auf die Leiterplatte (20) und
- Montieren und Anschließen eines Magnetfeldsensors (25) auf der Leiterplatte (20),
**dadurch gekennzeichnet, dass**
- der Magnetfeldsensor (25) als reines IC-Substrat gehäuselos vorliegt und so mit einer IC-Bestückungstechnik auf der Leiterplatte (20) montiert und angeschlossen wird.

6. Verfahren nach Anspruch 5, wobei die IC-Bestückungstechnik die Flip-Chip-Technik oder die wire-bond-Technik ist.

7. Verfahren nach Anspruch 5, wobei die IC-Bestückungstechnik auf der CSP-Technik basiert.
